## Europäisches Patentamt
## European Patent Office
## Office européen des brevets

(19)

(11) Publication number: **0 016 503**
**B1**

(12)

# EUROPEAN PATENT SPECIFICATION

(45) Date of publication of patent specification: **17.08.83**

(51) Int. Cl.³: **H 04 L 25/06**

(21) Application number: **80200239.4**

(22) Date of filing: **14.03.80**

(54) Waveform correction circuit.

(30) Priority: **16.03.79 NL 7902093**
**04.05.79 GB 7915682**

(43) Date of publication of application:
**01.10.80 Bulletin 80/20**

(45) Publication of the grant of the patent:
**17.08.83 Bulletin 83/33**

(84) Designated Contracting States:
**BE DE FR GB IT NL SE**

(56) References cited:
**GB - A - 2 006 570**
**US - A - 3 648 248**

(73) Proprietor: **N.V. Philips' Gloeilampenfabrieken**
**Groenewoudseweg 1**
**NL-5621 BA Eindhoven (NL)**

(72) Inventor: **Voorman, Johannes Otto**
**c/o INT. OCTROOIBUREAU B.V. Prof. Holstlaan 6**
**NL-5656 AA Eindhoven (NL)**
Inventor: **Summers, Christopher Paul**
**c/o INT. OCTROOIBUREAU B.V. Prof. Holstlaan 6**
**NL-5656 AA Eindhoven (NL)**

(74) Representative: **Van Mal, Louis Johannes et al,**
**INTERNATIONAAL OCTROOIBUREAU B.V.**
**Prof.Holstlaan 6**
**NL-5656 AA Eindhoven (NL)**

Courier Press, Leamington Spa, England.

Waveform correction circuit

The invention relates to a waveform correction circuit for obtaining at an output thereof a restored waveform of an input signal to be applied to an input of this correction circuit, input signal values which are slightly below a threshold value producing at the output an output signal of a first value, and input signal values which are slightly above that threshold value producing an output signal of a second value, this waveform correction circuit comprising a level control circuit for adapting the threshold level and a certain level in the input signal to one another by means of level control, the waveform correction circuit further comprising a slicer, an input of which is coupled to the input of the waveform correction circuit at least through the level control circuit and an output of which is coupled to an output of the waveform correction circuit, and an automatic amplitude control circuit for reducing by means of amplitude control the influence of amplitude variations of the input signal portion the waveform of which must be restored.

The United States Patent Specification 3 648 248 discloses a waveform correction circuit of the abovementioned type in which the slicer is a digit discriminator circuit. The amplitude of the input signal of the level control circuit is automatically controlled by means of an incremental corrector.

It is an object of the invention to improve the characteristics of a waveform correction circuit.

A waveform correction circuit of the type mentioned in the opening paragraph is therefore characterized in that an input of the amplitude control circuit for a signal to be controlled is coupled to an output of the slicer and an output of the amplitude control circuit is coupled to an input of a difference-determining circuit of which a further input is coupled to an input signal way of the slicer, an output of the difference-determining circuit being coupled to an input of the level control circuit.

The measure of putting the amplitude control circuit at the output of the slicer and obtaining the level control signal from the difference determining circuit as indicated, improves the speed of the control and consequently the accuracy of the waveform correction.

The invention will now be further explained by way of non-limitative example with reference to the accompanying drawing, which shows some embodiments.

In the drawing:

Figure 1 illustrates by means of a block schematic diagram a possible construction of a waveform correction circuit according to the invention and

Figure 2 illustrates, also by means of a block schematic diagram, an other possible construction of a waveform correction circuit according to the invention.

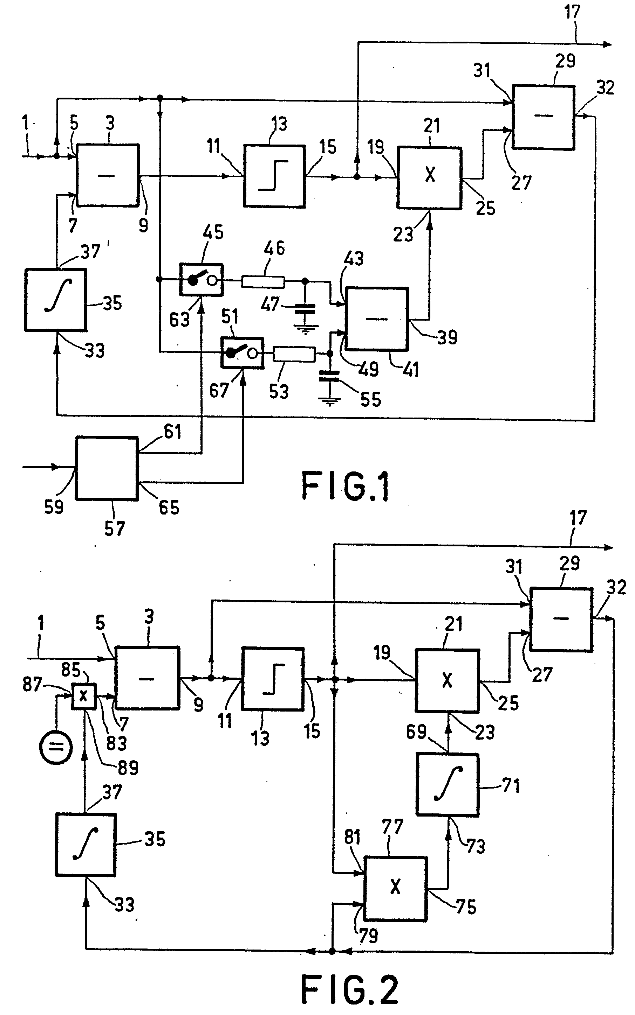

In Figure 1 there is applied to an input 1 an input signal containing code information expressed in two different signal values which correspond with a logic zero level and a logic one level. In this case this signal is a teletext signal received from a few line periods of the field blanking period of a television signal.

The logic zero level corresponds with the black level $b$ of the television signal and the logic one level corresponds with a level (b+a) in the television signal.

The levels $b$ and (b+a) can show variations caused by several disturbing influences on the transmission signal path.

In a level correcting circuit 3, which receives the input signal at an input 5, the level of the total input signal is corrected by a control signal applied to an input 7. The level-corrected input signal, which is applied to an input 11 of a slicer 13, appears at an output 9.

The slicer 13 supplies at an output 15 a signal which has a value zero when the signal at the input 11 is slightly below a certain threshold level and a value one when the signal at the input 11 is somewhat above this threshold level. This causes the input signal to appear in the waveform corrected form at the output 15 of the slicer. The waveform corrected signal is applied to an output 17 of the circuit and to an input 19 of a multiplier 21. To a further input 23 of this multiplier 21 an amplitude control signal is applied. The multiplier 21 functions as an amplitude control circuit for the signal applied to its input 19.

In response to the amplitude control signal at the input 23 the multiplier 21 converts the one value of the signal at its input 19 into a value which appears at its output 25 and which corresponds substantially with the a-value in the signal applied to the input 1. The signal at the output 25 is applied to an input 27 of a difference-determining circuit 29 to a further input 31 of which the input signal obtained from the input 1 is applied.

An error signal which corresponds to the difference between the signals at the inputs 27 and 31 is obtained from an output 32 of the difference-determining circuit 29. This error signal is applied to an input 33 of an integrator 35 from an input 37 of which the level control signal is obtained, which is applied to the input 7 of the level correcting circuit.

In combination with the difference-determining circuit 29 and the integrator 35, the level correcting circuit 3 forms a level control circuit for a level control which continuously adapts the level of the input signal to the threshold level such, that the output signal waveform which was restored by the waveform correction circuit corresponds as much as possible to an ideal waveform. To achieve this the difference-determining circuit 29 must have a sufficiently high gain.

The amplitude control signal applied to the input 23 of the multiplier 21 is obtained from an output 39 of a difference amplifier 41 having a gain factor of two.

A signal having a value $b$ is applied to an input 43 of the difference amplifier 41. This signal is obtained by way of a switch 45 which is connected to the input 1 and is closed each time the black level $b$ occurs in the input signal and which passes this black level $b$ to the input 43 by way of an integrating network 46, 47. A signal having a value b+1/2a) is applied to an input 49 of the difference amplifier 41. This signal is obtained by means of a switch 51 which is connected to the input 1 and is closed each time there appears at the input 1 a run-in signal consisting of a sequence of signal values preceding a teletext code message, which signal values alternately correspond with logic zero and logic one. The level (b+1/2a) is then obtained at the input 49 by way of an integrating network 53, 55. A signal having a value $2 \times (b+1/2a)-b=a$ is then produced at the output 39 of the difference amplifier 41, causing the output 25 of the multiplier 21 to supply a waveform which may assume the values zero and $a$.

The switches 45 and 51 are operated by a pulse generator 57 an input 59 of which receives a synchronizing signal obtained from the television signal. A switching signal is applied from an output 61 of the pulse generator 57 to an input 63 of the switch 45 and from an output 65 to an input 67 of the switch 51.

The multiplier 21, the difference amplifier 41, the integrating networks 46, 47 and 53, 55 and the switches 45, 51 form an automatic amplitude control circuit which, by controlling the amplitude of the signal at the input 27 of the difference-determining circuit 29 reduces the influence on the waveform correction of amplitude variations of that portion of the input signal (between $b$ and (b+a) whose waveform must be restored. This causes the waveform correction to be carried out more accurately and more rapidly then when the automatic amplitude control circuit were not present.

It will be apparent that the level correction circuit 3 and the slicer 13 may, if so desired, be combined to form one limiting difference amplifier.

If so desired, the output signal of the circuit may alternatively be taken from the output 25 of the multiplier 21.

A periodically occurring code combination other than the run-in signal may alternatively be used to obtain the signal at the input 49. The operation of the switch 51 and the gain factor of the difference-amplifier 41 must then be adapted.

If so desired, the integrating networks 46, 47 and 53, 55 may be replaced by one integrating network and the output of the amplifier 41.

It will further be obvious that, instead of the level in the signal at the input 11 of the slicer 13, the threshold level of the slicer might, if so desired, be corrected by means of the level control.

In Figure 2 elements whose functions correspond to those of elements in Figure 1 have been given the same reference numerals and are hence not further described.

The circuit of Figure 2 differs from that of Figure 1 in that the signal processing is adapted to the slicer 13, whose threshold level is at zero and the output signal is symmetrical relative to zero. Further, the automatic amplitude control is a continuously corrected control during the occurrence of the entire code message to be processed, so that also the influence of the above-mentioned amplitude variations owing to a limited bandwidth are compensated for.

The amplitude control signal applied to the input 23 of the multiplier 21 is received from an output 69 of an integrator 71, an input 73 of which is connected to an output 75 of a multiplier 77. The multiplier 77 multiplies the error signal which is received from the output 32 of the difference-determining circuit 29 and applied to an input 79 by the output signal of the slicer 13, which is applied to an input 81, which produces at the input 23 of the multiplier 21 a control signal the value of which is a mean value of the difference of the amplitudes of the signals at the inputs 27 and 31 of the difference-determining circuit 29. This difference is made as low as possible by the automatic amplitude control circuit formed by the multiplier 21, the difference-determining circuit 29, the multiplier 77 and the integrator 71, causing the amplitudes of the relevant signals at the inputs 27 and 1 of the difference-determining circuit to be continuously adapted to one another to the best possible extent.

The signal at the output 9 of the level correction circuit 3, which varies almost symmetrically around zero, as does also the output signal at the output 25 of the multiplier 21, is here used as the input signal to be applied to the input 31 of the difference-determining circuit.

The signal at the output 9 of the level correction circuit 3 varies almost symmetrically around zero in response to the level correction signal at the input 7, which in this case is obtained from an output 83 of a multiplier 85 whose input 87 is supplied with a direct current signal having a value one and whose input 89 receives the integrated error signal obtained from the output 37 of the integrator 35. So here the automatic level control circuit is formed by the difference-determining circuit 29, the integrator 35, the multiplier 85 and the level correction circuit 3.

The various remarks in the description of Figure 1 as regards possible alternative constructions apply here in a corresponding manner.

It will be obvious that also combinations of parts of a circuit according to Figure 1 with parts of a circuit according to Figure 2 are possible.

Waveform correction circuits with a multiple of threshold levels may be equipped with an automatic amplitude control according to the invention in an adapted way.

Although the circuits of the above-described embodiments are intended for the processing of teletext signals they can, of course, be adapted in a simple manner to the processing of other types of data signals, for which the circuits shown in Figure 2 can be used almost without any change.

**Claims**

1. A waveform correction circuit for obtaining at an output (17) thereof a restored waveform of an input signal to be applied to an input (1) of this correction circuit, input signal values which are slightly below a threshold value producing at the output (17) an output signal of a first value, and input signal values which are slightly above that threshold value producing an output signal of a second value, this waveform correction circuit comprising a level control circuit (3) for adapting the threshold level and a certain level in the input signal to one another by means of level control, the waveform correction circuit further comprising a slicer (13), an input (11) of which is coupled to the input of the waveform correction circuit at least through the level control circuit (3) and an output (15) of which is coupled to an output (17) of the waveform correction circuit, and an automatic amplitude control circuit (21) for reducing by means of amplitude control the influence of amplitude variations of the input signal portion the waveform of which must be restored, characterized in that an input (19) of the amplitude control circuit (21) for a signal to be controlled is coupled to an output (15) of the slicer (13) and an output (25) of the amplitude control circuit (21) is coupled to an input (27) of a difference-determining circuit (29) of which a further input (31) is coupled to an input signal way (1—11) of the slicer (13), an output (32) of the difference-determining circuit being coupled to an input (7) of the level control circuit (3).

2. A waveform correction circuit as claimed in claim 1, characterized in that a control signal input (23) of the amplitude control circuit (21) is coupled to an output (75) of a multiplier (77) of which an input (79) is coupled to the output (32) of the difference determining circuit (29) and a further input (81) is coupled to the output (15) of the slicer (13).

**Revendications**

1. Circuit de correction de forme d'onde permettant d'obtenir à une sortie (17) de ce circuit une forme d'onde rétablie d'un signal d'entrée à appliquer à une entrée (1) de ce circiuit de correction, des valeurs de signal d'entrée légèrement inférieures à une valeur de seuil produisant à la sortie (17) un signal de sortie d'une première valeur et des valeurs de signal d'entrée légèrement supérieures à la valeur de seuil produisant un signal de sortie d'une seconde valeur, ce circuit de correction de forme d'onde comprenant un circuit de réglage de niveau (3) servant à adapter le niveau de seuil et un certain niveau dans le signal d'entrée l'un à l'autre au moyen d'un dispositif de réglage de niveau, le circuit de correction de forme d'onde comprenant, en outre, un éminceur (13) dont une entrée (11) est couplée à l'entrée du circuit de correction de forme d'onde au moins par l'intermédiaire du circuit de réglage de niveau (3) et dont une sortie (15) est couplée à une sortie (17) du circuit de correction de forme d'onde, et un circuit de réglage automatique d'amplitude (21) pour réduire, par réglage d'amplitude, l'influence des variations d'amplitude de la partie de signal d'entrée dont la forme d'onde doit être rétablie, caractérisé en ce qu'une entrée (19) du circuit de réglage d'amplitude (21) destinée à un signal à régler est couplée à une sortie (15) de l'éminceur (13) et une sortie (25) du circuit de réglage d'amplitude (21) est couplée à une entrée (27) d'un circuit de détermination de différence (29) dont une autre entrée (31) est couplée à une voie de signal d'entrée (1 à 11) de l'éminceur (13), une sortie (32) du circuit de détermination de différence étannt couplée à une entrée (7) du circuit de réglage de niveau (3).

2. Circuit de correction de forme d'onde suivant la revendication 1, caractérisé en ce qu'une entrée de signal de réglage (23) du circuit de réglage d'amplitude (21) est couplée à une sortie (75) d'un multiplicateur (77) dont une entrée (79) est couplée à la sortie (32) du circuit de détermination de différence (29) et dont une autre entrée (81) est couplée à la sortie (15) de l'éminceur (13).

**Patentansprüche**

1. Wellenform-Korrekturschaltung zum Erhalten einer korrigierten Wellenform eines Eingangssignals an deren Ausgang (17), wobei die deren Eingang (1) zugeführten Eingangssignalwerte, die unter einem Schwellenwert liegen, an dem Ausgang (17) ein Ausgangssignal mit einem ersten Wert erzeugen, und Eingangssignalwerte, die über diesem Schwellenwert liegen, ein Ausgangssignal mit einem zweiten Wert erzeugen, wobei die Wellenform-Korrek-turschaltung eine Pegelregelschaltung (3) ent-hält, zum Anpassen des Schwellenpegels an einen bestimmten Pegel im Eingangssignal, wobei die Wellenform-Korrekturschaltung weiterhin einen Doppelbegrenzer (13) enthält, dessen Eingang (11) mit dem Eingang (1) der Wellenform-Korrekturschaltung wenigstens über die Pegelregelschaltung (3) gekoppelt ist und dessen Ausgang (15) mit dem Ausgang (17) der Wellenform-Korrekturschaltung gekoppelt ist, sowie eine automatische Amplitudenregelschaltung (21) zur Verringerung des Einflusses von Amplitudenschwankungen jenes Eingangssignalanteils, dessen Wellenform korrigiert werden soll, dadurch gekennzeichnet, dass ein Eingang (19) der Amplitudenregelschaltung (21) für ein zu regelndes Signal mit einem Ausgang (15) des Doppelbegrenzers (13) gekoppelt ist, dass ein Ausgang (25) der Amplitudenregelschaltung (21) mit einem Eingang (27) einer Differenzbestimmungsschaltung (29) gekoppelt ist, von der ein weiterer Eingang (31) mit einem Eingangssignalweg (1—11) des Doppelbegrenzers (13) gekoppelt ist, wobei ein Ausgang (32) der Differenzbestimmungsschaltung mit einem Eingang (7) der Pegelregelschaltung (3) gekoppelt ist.

2. Wellenform-Korrekturschaltung nach Anspruch 1, dadurch gekennzeichnet, dass ein Regelsignaleingang (23) der Amplitudenregelschaltung (21) mit einem Ausgang (75) einer Multiplizierschaltung (77) gekoppelt ist, von der ein Eingang (79) mit dem Ausgang (32) der Differenzbestimmungsschaltung (29) gekoppelt ist und wobei ein weiterer Eingang (81) mit dem Ausgang (15) des Doppelbegrenzers (13) gekoppelt ist.

FIG.1

FIG.2